# EUROPEAN PATENT SPECIFICATION

(11) **EP 2 694 706 B1**
(45) Date of publication and mention of the grant of the patent: **14.02.2018**
(21) Application number: 12717816.8
(22) Date of filing: 03.04.2012
(51) Int. Cl.: C30B 23/00, C30B 29/48, H01L 21/02

(54) **APPARATUS FOR CRYSTAL GROWTH AND METHOD OF PREPARING THE APPARATUS**
VORRICHTUNG ZUR KRISTALLZÜCHTUNG UND VERFAHREN ZUR HERSTELLUNG DER VORRICHTUNG
DISPOSTIF DE CROISSANCE CRISTALLINE ET PROCÉDÉ DE PRÉPARATION DU DISPOSITIF

(30) Priority: 08.04.2011 GB 201105958
(43) Date of publication of application: 12.02.2014
(73) Proprietor: Kromek Limited, Sedgefield, Durham TS21 3FD (GB)
(72) Inventor: ROBINSON, Max, Sedgefield Durham TS21 3FD (GB); MULLINS, John Tomlinson, Sedgefield Durham TS21 3FD (GB)
(74) Representative: Murgitroyd & Company
(86) International application number: PCT/GB2012/050746
(87) International publication number: WO 2012/136990

(56) References cited:
- WO-A1-2010/111473
- US-A1- 2001 004 877
- MULLINS J T ET AL: "Vapor-Phase Growth of Bulk Crystals of Cadmium Telluride and Cadmium Zinc Telluride on Gallium Arsenide Seeds", JOURNAL OF ELECTRONIC MATERIALS, vol. 37, no. 9, 8 April 2008 (2008-04-08), pages 1460-1464, XP55032990, SpringerLink ISSN: 0361-5235, DOI: 10.1007/s11664-008-0442-3
- CANTWELL B J: "Growth of CdTe bulk crystals by the multi tube physical vapour transport process; Chapter 3: 'MTPVT System'; Chapter 4 'Development of Crystal Growth in MTPVT System'; Chapter 5: 'Modelling the Growth of CdTe in hte MTPVT System'", Durham E-Theses Online, September 2004 (2004-09), pages 47-139, XP002680162, Durham University, Durham [GB] Retrieved from the Internet: URL:http://etheses.dur.ac.uk/3671/1/3671_1 232.pdf?UkUDh:CyT [retrieved on 2012-07-17]

## Description

The present invention relates to an apparatus for vapour phase crystal growth of single crystal materials, and in particular of single crystal semi-conductor materials for high-energy physics applications. The invention relates further to a method of preparing the apparatus. Single crystal materials have a number of important applications. For example, bulk cadmium telluride (CdTe) and cadmium zinc telluride (CZT) semiconductors are useful as x-ray and gamma-ray detectors which have application in security screening, medical imaging and space exploration amongst other things.

For many applications, it is desired to have single crystals of large size and thickness which can be formed rapidly with optimum uniformity and minimum impurities.

Traditionally, single crystals have been formed using direct solidification techniques, such as by the Bridgman, travelling heater (THM), gradient freeze (GF) or other liquid phase or self-seeding vapour phase crystal growth methods in which the crystals are grown from the melt. With these conventional methods, it has been difficult to form high quality crystals consistently, or to form single crystals having a diameter greater than 25mm or 50mm. In particular, with these known methods of crystal formation, dislocations, sub-grain boundaries and twins form easily. For high pressure Bridgman methods, there is also the potential problem of pipe formation. These problems are particular problems when forming CdTe crystals. The inclusion of zinc to make CZT reduces these problems to some extent as the zinc strengthens the lattice, however zinc segregation at the solidification interface may result in graded axial compositional profiles. However, higher temperatures are required for CZT growth, and this is undesirable. Also, the process tends to form precipitates and inclusions due to the excess tellurium in the melt. Tellurium inclusions can be tens of microns in size and this may be significant for detector applications. Further, there will be a dislocation cloud associated with each inclusion which will affect the performance of detectors formed from the crystal.

European Patent No EP1019568 (corresponding to WO 99/10571 A) discloses a method of forming crystals using a physical vapour phase technique. Mullins et al, "Vapor-Phase Growth of Bulk Crystals of Cadmium Telluride and Cadmium Zinc Telluride on Gallium Arsenide Seeds", Journal of Electronic Materials, 20080901 Minerals, Metals & Materials Society and IEEE not etc.| - ISSN 0361-5235; and Cantwell, B.J., "Growth of CdTe bulk crystals by the multi tube physical vapour transport process", Master thesis presented in candidature for the degree of Doctor of Philosophy in the University of Durham, 20040901; also describe apparatus for and method of forming bulk crystals of cadmium telluride and cadmium zinc telluride using a physical vapour phase technique.

This method has become known as Multi-Tube Physical Vapour Phase Transport (MTPVT). According to this method, a growth zone is defined for example in that a sink or seed crystal of the material to be grown is provided. Vapour phase material is provided to the growth zone, causing nucleation and subsequent deposition of the material to grow the crystal at the growth zone and for example onto the sink or seed crystal.

In the particular case the growth zone of a growth tube is connected to one or more source reservoirs in one or more source tubes, containing the required elements or compounds, via a flow restrictor incorporated into a demountable manifold, referred to as the crossmember. This enables transport of vapour from the source reservoir(s) to the growth zone. Crystal growth takes place, optionally on a suitable sink or seed crystal, above a pedestal located inside the growth tube. In use, the source reservoir(s) are heated to produce the vapour form of their respective contents which is transported via the crossmember to the growth zone.

During growth, the temperatures in the source and growth zones are controllable independently, the zones being thermally isolated. The source zone can thus be maintained at an appropriate evaporation temperature and the growth zone at an appropriate growth temperature. It is necessary to maintain the crossmember at a temperature higher than the source temperature in order to prevent unwanted condensation. Flow restrictors are required between the source and growth zones to allow the mass transport to be controlled without requiring an uncontrollably small source - growth temperature difference.

The envelope assembly comprising source tube(s), growth tube and crossmember is located inside a high vacuum vessel. The envelope assembly is evacuated prior to use to a relatively high quality vacuum which is maintained during the growth process. The envelope assembly is required to be sufficiently leak tight under growth conditions to prevent significant loss of vapour species to the vacuum vessel in which it is located. This is typically accomplished through the use of components manufactured from high purity quartz connected using tapered ground glass seals.

An annular gap between the pedestal and the growth envelope acts as another flow restrictor, allowing a pressure to be maintained above the growing crystal with only a relatively small loss of source material. This gap also allows the envelope assembly to be evacuated in preparation for the growth phase.

This Multi-Tube Physical Vapour Phase Transport process disclosed in EP1019568 is able to consistently produce crystals of a more uniform and higher quality. However, prior to heating the assembly to growth temperatures, it is necessary to evacuate the entire internal volume of the envelope through the annulus in the growth tube to prevent residual air or water vapour from contaminating the source material and growing crystal. The volume upstream of the pedestal, particularly that between the further flow restrictor(s) and the source(s), is difficult to evacuate effectively given the restricted flow passages involved. This leads to long pumping times and limits the quality of the vacuum which can be achieved.

According to one aspect of the present invention, there is provided an apparatus for vapour phase crystal growth comprising:
an envelope assembly having at least one source module defining at least one source volume, at least one growth module defining at least one growth volume, and at least one manifold module defining at least one manifold volume, wherein one or more source modules, a manifold module and a growth module are configured co-operably to define, in use in operation of the apparatus for vapour phase crystal growth, a fluidly continuous envelope volume including a flow restrictor between each source volume and the growth volume;
a vacuum vessel containing one or more such envelope assemblies;
an evacuator to evacuate the vacuum vessel;
a fluid communication path between the envelope volume and the vacuum vessel associated with each source volume at a location on the source volume side of its associated flow restrictor that is configurable to be selectively openable, in particular in use such as to be open during evacuation of the vacuum vessel to define a flow path from the source volume to the vacuum vessel during evacuation;
a closure mechanism configured to selectively restrict, and preferably substantially close, the fluid communication path between each source volume and the vacuum vessel as desired and in particular in use after evacuation.

The apparatus is thus in general a physical vapour transport crystal growth system such as the Multi-Tube Physical Vapour Phase Transport (MTPVT) described in European Patent No EP1019568. The apparatus forms an envelope assembly including at least one source volume and a growth volume which envelope assembly is substantially enclosed and can be evacuated to a relatively high vacuum for use. Each source volume includes at least one source zone in which a source may be provided for one or more of the required elements or compounds for the growth of the crystal in the growth zone. A growth volume includes at least one growth zone in which the crystal may be grown during a growth phase in use. One or more source modules, a manifold module and a growth module are configured co-operably to define a fluidly continuous envelope volume. The envelope volume is substantially closed save where apertures are specifically required or stipulated. One or more source modules, a manifold module and a growth module thus comprise parts of an envelope vessel enclosing the envelope volume, each module having module walls which collectively constitute the vessel walls when so assembled. In such configuration a source zone is typically at a first end of the envelope volume, the growth zone is at a second end remote therefrom, and the remainder of the source volume, the manifold volume, and the remainder of the growth volume together define a flow passage between the source zone and the growth zone for the flow of vapour from the source zone to the growth zone during the growth phase in accordance with the general principles set out in EP1019568.

Flow restrictors are provided in the flow passage at a point between the source zone and the growth zone for example at a location downstream of the source zone in the source volume or manifold volume. Suitable flow restrictors include a capillary or a sintered quartz disc. The flow restrictors are required during the growth phase to allow the mass transport to be controlled without requiring an uncontrollably small source - growth temperature difference, but in prior art systems such as that described in EP1019568 create the problems set out above during evacuation of the envelope volume, particularly that part between the flow restrictor(s) and the source(s), since the only source of evacuation to the vacuum vessel is via an aperture in the growth module downstream of the growth zone.

In accordance with the invention, this problem is solved in a distinctive manner by the provision of additional fluid communication flow paths out of the envelope at least between each source volume and the vacuum vessel at a location upstream of the associated source flow restrictor. These additional flow paths provide substantially higher conductance paths out of the envelope than is the case with the flow paths available in the prior art system. These additional flow paths are associated with selectively operable closure mechanism(s) configured to selectively restrict, and in the preferred case substantially close, the fluid communication flow path(s) between an evacuation phase during which the vacuum vessel and thereby the envelope volume is being evacuated and a growth phase subsequent thereto which takes place after establishment of a sufficient vacuum in the envelope volume. Thus, these additional flow paths are available during an evacuation phase to facilitate evacuation in particular of the areas of the envelope on the upstream side of the associated source flow restrictor, which are otherwise hard to evacuate via a downstream aperture in the manner of the prior art, facilitating the creation of the relatively high vacuum desired to optimise crystal growth, but are closed during a growth phase to facilitate maintenance of the relatively high vacuum within the envelope while minimising leaks to minimise loss of vapour species to the vacuum vessel during the growth phase.

Prior to use, the vacuum vessel is evacuated using the evacuator as usual and air is thus removed from the envelope volume to create the relatively high vacuum desired therein for the subsequent crystal growth phase. However, the envelope volume is not, as in the prior art, merely thereby evacuated via aperture(s) on the downstream or growth side of the flow restrictors that lie between the source and growth volumes (with the attendant difficulties in creating a high vacuum on the upstream or source side). Rather, the operation of the apparatus of the invention is characterized in that during the evacuation phase of operation of an envelope assembly within the evacuated vacuum vessel the closure mechanism(s) are set to an open configuration whereat fluid communication at least between each source volume and the vacuum vessel is enabled between that part of the envelope volume on the source volume side of each flow restrictor and the vacuum vessel via a secondary fluid communication path between the envelope volume and the vacuum vessel provided in association with each source volume at a location on the source volume side of its associated flow restrictor.

This is done by providing direct fluid communication path(s) between that part of the envelope volume on the source volume side of each flow restrictor and the vacuum vessel and so bypassing the flow restrictor. These secondary fluid communication path(s) may be provided at a location into/ out of any part of the envelope volume on the source volume side of the flow restrictor, whether providing a flow path directly from the source volume in the narrow sense, or more generally via the rest of that part of the envelope volume on the source side of the flow restrictor, for example in a part of a manifold volume that is on the source side of the flow restrictor and in fluid communication with the source volume. Preferably, the secondary fluid communication path out of the envelope volume is at a location between the source and the associated flow restrictor. For example, in familiar manner, a source module may define a source zone provided with a source in use, spaced from the associated flow restrictor, and the fluid communication path between the envelope volume and the vacuum vessel may then comprise a direct fluid communication between the envelope volume and the vacuum vessel at a location between the source zone and the associated flow restrictor.

In this way, a flow path out of the source volume bypassing the flow restrictor is provided. This provides a flow path out of the envelope during an evacuation phase that allow high conductance out of the envelope, substantially higher than the conductance during evacuation possible in the prior art, at least in those cases such as in EP1019568 where the available flow paths for evacuation of the source zone(s) upstream of the flow restrictor(s) are via flow restrictor(s) and the growth zone. Evacuation thus proceeds much more rapidly than it would solely via the aperture in the growth module downstream of the growth zone made use of in the prior art apparatus. In particular, evacuation of those parts of the envelope on the upstream, source side of the flow restrictor(s) proceeds more rapidly and the creation of the desired high quality vacuum is facilitated.

Then, during a growth phase of operation of an envelope assembly within the evacuated vacuum vessel the closure mechanism(s) are set to a configuration whereat the secondary fluid communication path between each source volume and the vacuum vessel upstream of the flow restrictor is restricted, at least sufficiently to keep material losses through the direct fluid communication path(s) to an acceptably low level, and preferably substantially entirely closed. Thus, during the growth phase of operation, the envelope may be made sufficiently leak tight under growth conditions to prevent significant loss of vapour species to the vacuum vessel in which it is located.

The envelope assembly may then in the growth phase operate in conventional manner, for example in that flow is effected through the flow restrictor and via an aperture in the growth module downstream of the growth zone such as is made use of in the prior art apparatus.

Thus, the apparatus of the invention may operate conventionally, for example in the manner of the apparatus of EP1019568, in the growth phase, but evacuate much more efficiently, for example more rapidly and/ or down to a more consistent lower base pressure, in the evacuation phase of operation. The apparatus of the invention meets the apparently conflicting requirements for rapid and high quality evacuation of all zones prior to crystal growth but a substantially leak proof envelope with controlled and restricted flow through and out of the growth zone during crystal growth in admirable manner by provision of a selectively closable flow path in association with the or each part of the envelope volume on the source side of the flow restrictor(s).

In accordance with the invention, such a flow path and closure mechanism is provided at least in association with the or each part of the envelope volume on the source side of the relevant associated flow restrictor, since this part of the envelope volume is hardest to evacuate in the manner of the prior art apparatus, where flow during an evacuation phase is through the flow restrictor and via an aperture in the growth volume downstream of the growth zone. For ease of reference herein the source side of the relevant associated flow restrictor may be referred to as the side "upstream" of the relevant flow restrictor and the other side as the "downstream" side. It will be apparent that in this context, "upstream" and "downstream" are used with reference to a conventional flow direction during the growth phase which does not necessarily coincide with an evacuation flow direction during an evacuation phase. Where this terminology is used it will be appreciated by the skilled person that reference is being made to the conventional growth phase flow direction where applicable.

The invention does not preclude further fluid communication paths/ selective closure mechanism(s) associated with further parts of the envelope volume, for example downstream of such a flow restrictor; that is, in association with a part of the envelope volume on the growth side of the flow restrictor and thus in association with the growth volume. Preferably, such a secondary fluid communication path out of the growth volume is at a location between the growth site and the flow restrictor (s). For example, in familiar manner, a growth module may define a growth zone serving as a growth site in use spaced from the associated flow restrictor(s) and a fluid communication path between the envelope volume and the vacuum vessel may comprise a direct fluid communication between the envelope volume and the vacuum vessel at a location between the growth zone and the flow restrictor(s) that is configurable to be selectively openable, for example in use during evacuation, by means of a closure mechanism configured to selectively restrict, and preferably substantially close, the fluid communication path between the growth volume and the vacuum vessel as desired and in particular in use after evacuation. For example, closeable flow path and closure mechanisms may be provided in a manifold volume downstream of a flow restrictor and/ or in a growth volume upstream of a growth zone to selectively close a fluid communication between the envelope volume and the vacuum vessel at a location between the flow restrictor and the growth zone. This may also assist in evacuation of the envelope volume.

Where fluid communication paths/ selective closure mechanism(s) are provided in association with further parts of the envelope volume in addition to those provided in association with the or each source volume, the foregoing principles of operation during an evacuation phase of operation and during a growth phase of operation will apply in equivalent manner.

Three mechanisms in particular are envisaged to create a selectively operable closure mechanism in an apparatus of the invention.

In accordance with the general principles embodied by the first two example mechanisms, a reversible mechanically operable closure mechanism, for example operable under user control, to selectively open and restrict/ close the secondary flow paths is envisaged.

In accordance with these general principles, the apparatus is configured alternatively and selectively to define:
an open configuration in which one or more secondary fluid communication paths between the envelope volume and the vacuum vessel as above defined, and in particular at least between the vacuum vessel and a part of each source volume at a location on the source volume side of its associated flow restrictor, are open to allow direct flow from such parts of the envelope to the vacuum vessel for example in use during evacuation;
a closed configuration in which the one or more secondary fluid communication paths between the envelope volume and the vacuum vessel as above defined are selectively restricted, and preferably substantially closed, to limit and preferably substantially prevent direct flow from such parts of the envelope to the vacuum vessel for example in use during growth;
a mechanically actuated closure mechanism adapted to selectively and reversibly effect a change between the said open and closed configurations.

Preferably, the closure mechanism is mechanically actuated via an actuator operatable externally of the pressure vessel, outside the evacuated volume in use, for example via a suitable sealed mechanical feedthrough from outside the pressure vessel.

In this way, in the open configuration, the associated part(s) of the envelope volume may be evacuated directly via the open secondary flow paths, but in the closed configuration, the primary flow path is then via the flow restrictor and growth zone to the growth module outlet in the same manner as the prior art. Thus, the envelope volume may be evacuated in the distinctive and advantageous manner of the invention during an evacuation phase, but be susceptible of conventional operation in a subsequent growth phase.

First, an aperture with a removably insertable closure formation may be provided in a wall of a module surrounding the envelope volume. For example, at least, an aperture with a removably insertable closure formation may be provided in a wall of a module surrounding that part of the envelope volume located on a source volume side of an associated source flow restrictor. For example, at least, an aperture with a removably insertable closure formation may be provided in a wall of a source module and/ or manifold module upstream of the associated source flow restrictor. Optionally also, an aperture with a removably insertable closure formation may be provided in a wall of a module surrounding that part of the envelope volume on a growth volume side of the source flow restrictor(s). For example an aperture with a removably insertable closure formation may be provided in a wall of a manifold module and/ or growth module downstream of the source flow restrictor(s) and upstream of the growth zone.

With the removably insertable closure formation removed, the aperture provides direct fluid communication between the vacuum vessel and that part of the envelope volume. With the removably insertable closure formation in place, this flow is restricted, and preferably a substantially leak proof seal is made of the aperture, such that direct fluid communication between the vacuum vessel and that part of the envelope volume is substantially restricted and preferably essentially no longer possible. Thus, with the removably insertable closure formation removed, that part of the envelope volume may be evacuated directly, but with the removably insertable closure formation in place, the primary flow path is then via the flow restrictor and growth zone to the growth module outlet in the same manner as the prior art. Thus, the envelope volume may be evacuated in the distinctive and advantageous manner set out above during an evacuation phase, but be susceptible of conventional operation in a subsequent growth phase.

In a possible embodiment the removably insertable closure formation comprises a plug adapted to be removably received in a socket formation defining an aperture in the wall of the module in substantially leak tight manner. For example a plug has a tapered projecting portion adapted to be received in a complementarily shaped socket formation surroundingly defining an aperture in the wall of the module. For example a plug is a glass plug. For example the taper formation and socket formation define ground glass joints to effect a substantially leak proof seal.

It is desirable that selective closure of the apertures may be effected from outside the vacuum vessel. Conveniently therefore each removably insertable closure formation is provided with an actuator to effect its removal from and reinsertion into the aperture, which actuator is configured to be operable from outside the vacuum vessel without compromising the vacuum within the vacuum vessel.

Second, one or more of the modules making up the envelope volume, and in particular at least the source module(s), may be selectively assemblable and dissassemblable from the whole, preferably being provided with joints that are substantially leak proof when so assembled. With the modules disassembled, the parts of the envelope volume they define are placed in direct fluid communication with the vacuum vessel. A substantial evacuation flow is possible in an evacuation phase. With the modules reassembled, this flow is restricted for a growth phase. In particular preferably a substantially leak proof seal is made at the joint between each module, and direct fluid communication between the vacuum vessel and that part of the envelope volume is substantially restricted and preferably essentially no longer possible. For example, substantially leak proof mating joints such as ground glass joints are provided at the jointing points whereat the source modules are assembled.

Thus, with the envelope disassembled, parts of the envelope volume upstream of the floe restrictors may be evacuated directly, but with the envelope assembled, the primary flow path is then via the flow restrictors and growth zone to the growth module outlet in the same manner as the prior art. Thus, the envelope volume may be evacuated in the distinctive and advantageous manner set out above during an evacuation phase, but be susceptible of conventional operation in a subsequent growth phase.

It is desirable that selective assembly and dissassembly of the modules may be effected from outside the vacuum vessel. Conveniently therefore the system is provided with an actuator to effect selective assembly and dissassembly of the modules, which actuator is configured to be operable from outside the vacuum vessel without compromising the vacuum within the vacuum vessel.

Third, an evacuation orifice may be provided in a source module upstream of the source zone (where, again, "upstream" is defined relative to a growth flow direction in growth mode). This may provide an additional pumping path for the volume above the source material. Many sources for evaporation in the growth phase are originally provided in a powder or similar unconsolidated form prior to heating that tends to consolidate on heating. In this unconsolidated form, the orifice is effective during evacuation prior to heating as a flow route from the source volume through the unheated and unconsolidated source material. However, with a suitably sized hole and a suitable temperature gradient for the source heater, it has been found that consolidation for example by compaction of the source material during heating reduces loss during operation in the growth phase to a small fraction of the source mass as the said flow route is restricted when the source material is consolidated on heating.

In practice then, the closure mechanism in this third alternative case is one based on the inherent behaviour of the source material on heating. It is in a sense self-actuating. By appropriate selection, an orifice/ material combination can be provided which serves as an open flow path between source volume and vacuum vessel prior to heating (and hence during evacuation), but which is substantially restricted by the source material after heating (and hence during growth).

In principle the invention encompasses any of the foregoing alone or in combination with each other and / or in combination with other selectively closeable secondary flow path means. In practice the first and second mechanisms listed above are likely in the preferred case to be alternatives. In practice the third mechanism listed above is likely in the preferred case to be used complementarily to another mechanism, such as one or other of the first two mechanisms above described, rather than as the sole selectively closeable secondary flow path means.

Except in a case where the selectively closeable secondary flow path mechanism specifically requires the provision of discrete demountable modules, the invention does not preclude arrangements in which at least some of the modules collectively defining the fluidly continuous envelope volume constitute parts of an integral formation. Generally however, in the preferred case, modules are discrete and demountable formations enabling assembly and disassembly of the fluidly continuous envelope prior to use for example for loading with source materials, even if such assembly and disassembly is not used as the means of providing selectively closeable secondary flow paths in accordance with the principles of the invention. Such modules are preferably adapted to be assembled in substantially leak tight manner to provide a substantially leak tight envelope volume when so assembled.

A module conveniently comprises a vessel wall defining an internal volume and is for example tubular and elongate with a continuous tubular wall structure extending between spaced first and second ends whereat fluid communication is effected with adjacent modules and /or where a closure or partial closure is provided. In the case of an embodiment comprising demountable modules, such ends as are to be mounted to adjacent modules are provided with mounting joints preferably adapted to be assembled to be substantially leak tight.

In a possible embodiment, modules may comprise glass tubes, for example of high purity quartz glass, connected to adjacent modules where applicable using mutually co-operating tapered ground glass seals. In such an embodiment, in cases where a glass tube is provided with a secondary aperture in a tube wall as a flow path means to the vacuum vessel having a removably insertable closure formation, the removably insertable closure formation conveniently comprises a tapered glass stopper, the stopper and aperture being similarly provided with ground glass seals.

Each source zone and growth zone may be provided with means for independent temperature control within the zone, the zones being thermally decoupled in the manner described in EP1019568 to facilitate evaporation at the source zone, vapour phase transport to the growth zone, and crystal growth at the growth zone on a growth substrate for example on a seed crystal or a partly grown crystal of target material.

A seed crystal substrate can be formed from various materials. However, preferred materials for these seed substrates are silicon and gallium arsenide. An advantage of forming crystals on a silicon and gallium arsenide substrate is that these substrates have good mechanical strength and commercially available at an acceptable price. This both helps ensure that the crystal material is consistently formed on the substrate, which may be more difficult with a less robust substrate, and also helps maintain the integrity of the formed material in subsequent processing, use and transportation.

Such a seed substrate may be of any size required, depending upon the required size of the crystal material. However, it is preferred that the substrate has a diameter greater than 25 mm, preferably greater than 50 mm, and most preferably at least 150 mm.

The crystal materials formed may include group II-VI semiconductors such as semiconductors of the cadmium telluride type, and for example comprise crystalline Cd_{1-(a+b)}MnₐZn_{b}Te where a+b <1 and a and/ or b may be zero.

The crystal materials are preferably formed as a bulk crystal, and for example as a bulk single crystal (where bulk crystal in this context indicates a thickness of at least 500 µm, and preferably of at least 1 mm). It is an advantage of the apparatus and method of the invention that it facilitates the preparation of high quality large size bulk crystal material products.

Separate control of the source temperature (T_{source}) and the substrate temperature (T_{sub}). A variation in the source and/or substrate temperature will result in a change of the temperature differential (ΔT). By increasing the temperature differential, for example by increasing the source temperature, the overall growth rate may be increased.

By way of example, in the case of cadmium telluride, typically, the minimum source temperature will be around 450°C to ensure the sublimation of the material. At temperatures lower than this, no substantial sublimation will occur. Similarly by example, for cadmium telluride the minimum substrate temperature is around 200°C. It will be appreciated that the growth and sublimation temperatures are dependent on the material being deposited. For example, the growth temperature for mercury iodide is around 100 to 150°C and the sublimation temperature is around 200 to 300°C. Minimum and optimum source and substrate temperatures will vary correspondingly.

The modules collectively defining the fluidly continuous envelope as hereinbefore defined comprise at least one flow passage for vapour transport from a source zone to a growth zone in use, in particular preferably for use in manner embodying the principles of physical vapour phase transport described in EP1019568.

In particular, in accordance with these principles, the or each flow passage so defined deviates from a straight line at at least two points between source and growth zones, for example deviating from a straight line at or about a junction between the source module and the manifold module and at or about a junction between the manifold module and the growth module. This deviation helps to keep source and growth zones thermally isolated. This thermal isolation assists in ensuring and controlling the temperature differential between the source and growth zones, and therefore assists with the control of crystal growth.

Preferably the deviation from a straight line is at least 5 degrees, more preferably at least 45 degrees, and in many instances conveniently approaches 90 degrees, whereby the source module, manifold module, and growth module collectively define a U-shaped flow passage for vapour transport from a source zone to a growth zone in use.

Thus, in the preferred case, the modules making up the envelope volume define a generally U-shaped tubular envelope having a source limb, a growth limb, and a flow passage connecting the first and second limbs, the source limb being arranged to contain a source material, and the growth limb being arranged to support growth. A source flow restrictor is provided between first and second limbs. The invention admits arrangements with plural such first or second limbs

In a particularly preferred case, a source module and a growth module are provided which are disposed substantially parallel to each other and for example upright, for example so as to define such a source limb and growth limb, with a manifold module comprising a cross member extending between them.

In a preferred case the source zone and growth zone are located respectively at ends of the source module and growth module furthest from each other and from the manifold module. For example, the source zone and growth zone are located respectively at lower ends of the source module and growth module with the remainder of the source volume and growth volume constituting flow passages extending substantially upwardly therefrom and joined fluidly by the manifold module thereby providing for optimal vapour transport from the source zone to the growth zone.

An envelope volume as hereinbefore defined may comprise a plurality of source zones, for example each associated with a passage for vapour transport, which passages may converge or otherwise, thereby having a common or separate passageways proximal to a single growth zone. By this means, a plurality of source zones may be located about a common growth zone, for example radially or extending outwardly to one side thereof. For example, where two separate sources are required for formation of a single crystal in a common growth zone, the envelope volume will comprise a source volume including the first source material connected to the growth volume via a first manifold volume, and a further source volume including the second source material connected to the growth volume via a second manifold volume. A common manifold module may define such manifold volumes.

Alternatively a plurality of source zones may be associated with a plurality of separate growth zones. The inclusion of multiple growth zones permits the simultaneous growth of multiple crystals of the same or different composition.

Where multiple source volumes are provided, any or all of these may be provided with independent flow restrictors.

Such a plurality of source zones may be independently activated by means of independent temperature control means associated with each source zone, whereby vapour may be generated sequentially or simultaneously from respective source zones with the required temperature differentials. Additionally or alternatively the temperature profile may be varies by appropriate configuration such that the plural sources are positioned within a common temperature profile in use with respect to each other and to the growth zone to provide the required temperature differentials.

In a preferred embodiment a plurality of source zones may be adapted to contain a combination of different elemental or compound source material providing each element or compound respectively of a binary, ternary or other multinary compound, for example in the manner of the Multi-Tube Physical Vapour Phase Transport (MTPVT) described in European Patent No EP1019568.

The source and growth zones are conveniently adapted to comprise source material and seed crystal as known in the art, for example in the form of one or more reservoirs of source material and a crystal of seed material. Preferably the one or more reservoirs of source material comprise material in solid phase supported on a glass or other suitable surface or pedestal adapted to the processing conditions to be employed, allowing convenient and efficient vaporisation.

Where multiple sources are provided, the composition of the crystal material deposited may be changed during the growth. This control may be achieved by control of the flow restrictors, or by the temperature gradient between the source and growth zones. In one example, the crystal material is initially deposited at a low deposition rate, with the deposition being controlled to increase the rate of deposition.

In accordance with a further aspect of the invention, a method of preparing an apparatus for vapour phase crystal growth comprises the steps of:
providing an envelope assembly having at least one source module defining at least one source volume, at least one growth module defining at least one growth volume, and at least one manifold module defining at least one manifold volume, wherein one or more source modules, a manifold module and a growth module are configured co-operably to define a fluidly continuous envelope volume including a flow restrictor between each source volume and the growth volume;
defining a source zone in each source volume and providing a source of growth material therein;
defining a growth zone in each growth volume, and optionally providing a seed crystal therein;
disposing one or more such envelope assemblies in a vacuum vessel, each configured in such manner that a fluid communication path between the envelope volume and the vacuum vessel is provided associated with each source volume at a location on the source volume side of its associated flow restrictor;
evacuating the vacuum vessel and thereby evacuating the envelope volume, in part at least by evacuating each source volume directly via the fluid communication path associated with the source volume at a location on the source volume side of its associated flow restrictor;
operating a closure mechanism configured to selectively restrict, and preferably substantially close, the fluid communication between each source volume and the vacuum vessel for a subsequent growth phase of operation.

Thus, in this manner, the envelope volume is evacuated during an evacuation phase not merely via the primary flow path through the growth zone aperture, and in particular those parts of the envelope volume lying upstream of the source flow restrictors that are provided between the source and growth zones are not evacuated merely via the primary flow path through the flow restrictors (with the attendant difficulties in creating a high vacuum on the upstream or source side). Rather, the method comprises in part at least evacuating each source volume directly via the secondary fluid communication path associated with the source volume at a location on the source volume side of its associated flow restrictor. Evacuation is facilitated. In particular, evacuation of those parts of the envelope on the upstream, source side of the flow restrictor(s) proceeds more rapidly and the creation of the desired high quality vacuum is facilitated.

However, during a subsequent growth phase of operation the secondary fluid communication path between each source volume and the vacuum vessel upstream of the flow restrictor may be restricted, at least sufficiently to keep material losses through the direct fluid communication path(s) to an acceptably low level, and preferably substantially entirely closed. Thus, during the growth phase of operation, the envelope assembly may operate in conventional manner, for example in that flow is effected through the flow restrictor and via an aperture in the growth module downstream of the growth zone such as is made use of in the prior art apparatus.

At its broadest, the method of preparing an apparatus for vapour phase crystal growth is a method of operation of the apparatus of the first aspect of the invention up to the end of the evacuation phase in preparation for subsequent crystal growth in familiar manner. Preferred features of the method may be derived from the foregoing description of the apparatus by analogy.

In particular, the method is characterized by the provision of additional flow paths out of the envelope at least between each source volume and the vacuum vessel at a location upstream of the associated source flow restrictor during the evacuation phase, with selectively operable closure mechanism(s) configured to be operated to selectively restrict, and in the preferred case substantially close, the flow path after the evacuation phase and before a growth phase in the manner above described in relation to the first aspect of the invention.

In particular by analogy with the foregoing description of the apparatus, the method comprises providing a flow path and closure mechanism at least in association with the or each source volume upstream of the relevant associated flow restrictor although the invention does not preclude further openable closure mechanism(s) elsewhere in the envelope volume and for example downstream of such a flow restrictor. Suitable locations will be understood by analogy with those discussed in relation to the first aspect of the invention.

In particular by analogy with the foregoing description of the apparatus of the first aspect of the invention, three example mechanisms are envisaged to create a selectively operable closure in an apparatus of the invention.

In particular by analogy with the foregoing description of the apparatus of the first aspect of the invention, the general principles embodied by the first two example mechanisms are those of a reversible mechanically operable closure mechanism, for example operable under user control, to selectively open and restrict/ close the secondary flow paths.

In accordance with these general principles, the apparatus is configured alternatively and selectively to define an open configuration and a closed configuration as above described, and the method comprises a step of operation of a mechanically actuated closure mechanism to selectively and reversibly effect a change between the said open and closed configurations.

In a first example, an aperture with a removably insertable closure formation may be provided in a wall of a module surrounding the envelope volume. The method then comprises the steps of removing the removably insertable closure formation during the evacuation phase to provide direct fluid communication between the vacuum vessel and that part of the envelope volume and inserting the removably insertable closure formation at the end of the evacuation phase in preparation for a growth phase such that direct fluid communication between the vacuum vessel and that part of the envelope volume is for example substantially restricted and preferably essentially no longer possible.

In a second example, one or more of the modules making up the envelope volume, and in particular at least the source module(s), are provided such as to be selectively assemblable and dissassemblable from the whole. The method then comprises the steps of disassembling the modules during the evacuation phase whereby the parts of the envelope volume they define are placed in direct fluid communication with the vacuum vessel and reassembling the modules at the end of the evacuation phase in preparation for a growth phase whereby direct fluid communication between the vacuum vessel and that part of the envelope volume is for example substantially restricted and preferably essentially no longer possible.

In a third example, an evacuation orifice may be provided in a source module upstream of the source zone. The method comprises providing a source material in a form that permits flow through the material when it is unheated during the evacuation phase, but which inherently tends to consolidate for example by compaction and substantially restrict through flow when heated in preparation for a growth phase. In this case the step of operating a closure mechanism configured to selectively restrict, and preferably substantially close, the fluid communication between each source volume and the vacuum vessel for a subsequent growth phase of operation is in fact inherent in the heating of the source for the growth phase.

Other preferred features of the method will similarly be understood by analogy with those discussed in relation to the apparatus of the first aspect of the invention.

In an example implementation of the method of the invention, a method of vapour phase crystal growth comprises the steps of preparing an apparatus in accordance with the second aspect of the invention in an initial evacuation phase; and subsequent operation of the apparatus in a growth phase; in particular by:
heating the source material(s) to a suitable evaporation temperature;
heating the growth zone and where applicable the seed crystal to a suitable growth temperature;
maintaining the same to facilitate physical vapour transport from the source zone to the growth zone and grow a bulk crystal material at the growth zone.

Thus, the method may comprise in a growth phase a known physical vapour transport growth process with its attendant advantages in terms of the speed of formation and quality of the crystal material. It is preferred that the bulk crystal material is grown using a multi-tube physical vapour phase transport method, such as that disclosed in EP1019568. The method allows high quality large size bulk crystal material to be formed quickly using physical vapour phase deposition methods, enabling the required thickness of material to be formed in an acceptable time. The refinement of the method substantially speeds up the evacuation phase and/ or improves the vacuum quality, so further enhancing these advantages.

The invention will now be described by way of example only with reference to figures 1 to 5 of the accompanying drawings, wherein:
Figure 1 shows a prior art multi-tube physical vapour phase transport device for growing crystal structures
Figure 2 shows an example of a multi-tube physical vapour phase transport device for growing crystal structures modified according to the principles of an embodiment present invention, and shown in an evacuation phase configuration;
Figure 3 shows an alternative example of a multi-tube physical vapour phase transport device for growing crystal structures modified according to the principles of an embodiment present invention, also shown in an evacuation phase configuration;
Figure 4 shows the multi-tube physical vapour phase transport device of figure 3 in a growth phase configuration; and
Figure 5 shows a further alternative example of a multi-tube physical vapour phase transport device for growing crystal structures modified according to the principles of an embodiment present invention, in an evacuation phase configuration.

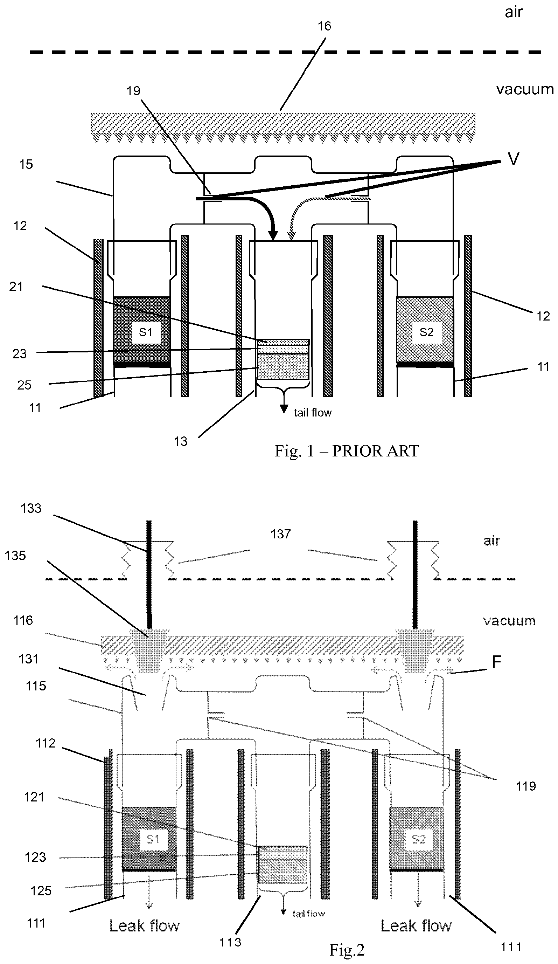

A suitable known apparatus for the formation of bulk single crystal materials is shown in figure 1. The apparatus is for example one embodying the Multi-Tube Physical Vapour Phase Transport process disclosed in EP1019568.

The example apparatus comprises a tubular envelope made up of a pair of vertically disposed source tubes (11) each defining a source zone at its lower end, a vertically disposed growth tube (13) defining a growth zone at its lower end, and a crossmember tube (15). In the illustrated embodiment a first source (S1) is provided in the first source zone and a second source (S2) in the second source zone. The embodiment is thus a plural source, single sink example with a common crossmember, but this is merely an example of a suitable arrangement of source/ growth/ crossmember modules.

For example, the source material may be a source of cadmium telluride and zinc telluride which forms a cadmium telluride or cadmium zinc telluride crystal on a cadmium telluride seed crystal. However, many other crystals may be grown on suitable seed crystals.

Separate and independently controllable vertical tubular furnaces (12), each for example defining plural heating zones, are provided for the source and the growth zones respectively. The horizontal crossmember tube (15) may optionally be heated by a crossmember heater (16). Alternatively, a single multi-zone heater could be provided arranged to heat a heated zone of the tubular furnaces to give a predetermined temperature profile along the length of the heated zone.

The source tube, growth tube and crossmember in the embodiment are fabricated from quartz and the system is demountable with ground glass joints between the crossmember and the two vertical tubes allowing removal of grown crystals and replenishment of source material.

The whole assembly forms a quartz envelope volume defining a flow passage between each source zone and the growth zone. A flow restrictor (19) such as a capillary or a sintered quartz disc is provided in each passage so defined, between the source zone and the growth zone, and in the example within the manifold volume defined by the crossmember tube. Flow restrictors are required between the source and growth zones to allow the mass transport to be controlled without requiring an uncontrollably small source - growth temperature difference.

A vacuum jacket surrounds the entire system.

Each flow passage so defined comprises two separate points of deviation at an angle of 90° respectively as the flow path passes from vertical source tube to horizontal crossmember and from horizontal crossmember to vertical growth tub. As will be familiar this decouples the source and growth tubes thermally and may provide sites for additional functionality, for example for in-situ monitoring via windows allowing optical access to source and growth zone, temperature measurement at the surface of growing crystal by a pyrometer or other optical diagnostic apparatus etc.

Growth takes place on a substrate in the growth zone. In a preferred case, growth of the crystal (21) take place on a seed crystal (23) held in the growth zone on a support pedestal (25). For some applications, such as detector applications, a bulk crystal material may be required having a large area. However, in the case of such materials, seed crystals of sufficiently large size may not be available, or may only be available at high cost. In such a case, it may be desirable to form the crystal material on a seed crystal of a different material, for example on a silicon or gallium arsenide seed crystal, that it more easily or cheaply available. This can be achieved by the use of a seed crystal comprises a crystal of a material different from the material to be deposited, the seed crystal being provided with an intermediate layer or region onto which a bulk crystal material is deposited using the apparatus of the present invention.

Growth takes place on a substrate located on a quartz block (25) in the growth tube with the gap between this glass block and the quartz envelope forming the downstream flow restrictor which provides for an annulus flow downstream of the growth region. During the growth phase, tail flow through the downstream flow restrictor drives vapour flow to the growth regions. During the evacuation phase the annulus tail flow assists in evacuation. In addition to being a consequence of the requirement for evacuation, is to allow removal of any excess precursor species which might otherwise build up above the growing crystal and affect vapour transport, growth rate and the composition of the growing crystal.

The various flow restrictors serve to minimize loss of material during the growth phase. However, the presence of these flow restrictors complicates the evacuation of the system in advance of the growth phase. Prior to heating the assembly to growth temperatures, it is necessary to evacuate the entire internal volume of the quartz envelope to prevent residual air or water vapour from contaminating the source material and growing crystal. The only flow path from the envelope volume to the evacuated volume available to effect this is via the flow path V through the flow restrictors (19) and via the tail flow through the annulus in the growth tube. The envelope volume upstream of the pedestal, particularly that between the flow restrictors and the sources, is difficult to evacuate effectively due to the restricted passages involved. This leads to long pumping times and limits the quality of the vacuum which can be achieved.

The invention addresses this problem by providing secondary flow paths from the envelope volume to the evacuated volume that can be selectively open to high flow rates during evacuation but restricted to low/ negligible flow rates during growth. An example approach for making such provision is illustrated in figures 2 to 4.

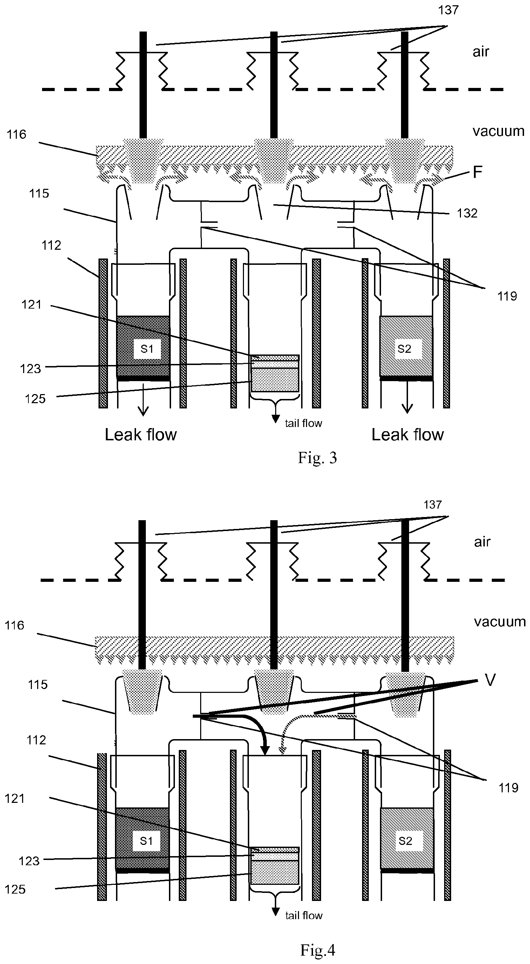

The principle embodied in figures 2 to 4 is that of provision of apertures in the quartz envelope with removable plugs to provide (when the plugs are removed) secondary flow paths for evacuation in accordance with the principles of the invention. Figure 2 shows a first arrangement with apertures in the quartz envelope in the source regions, in an evacuation phase configuration. Figure 3 shows a second arrangement with apertures in the quartz envelope in the source and growth regions, in an evacuation phase configuration. Figure 4 shows the figure 3 arrangement in a growth phase configuration.

The apparatus illustrated embodies similar principles to that of figure 1. A quartz tubular envelope is again provided made up of a pair of vertically disposed source tubes (111) each defining a source zone at its lower end, a vertically disposed growth tube (113) defining a growth zone at its lower end, and a crossmember tube (115). The whole assembly forms a quartz envelope volume defining a flow passage between each source zone and the growth zone. A first source (S1) is provided in the first source zone and a second source (S2) in the second source zone. Separate vertical tubular furnaces (112) are provided for the source and the growth zones respectively and a crossmember heater (116) for the crossmember tube. Flow restrictors (119) in the crossmember tube substantially restrict flow between each source and the growth site.

A vacuum jacket again surrounds the entire system.

Growth of the crystal (121) takes place in a growth phase on a seed crystal (123) held in the growth zone on a support pedestal (125).

The apparatus is modified for evacuation by the addition of apertures (131) in the quartz envelope with removable plugs (135) to provide (when the plugs are removed) secondary flow paths (F) from the envelope volume. In figure 2 apertures provide such secondary flow paths (F) above the sources at a point between the source and the respective flow restrictor. In figure 3 a further aperture (132) provides a further flow path above the growth zone at a point downstream of the flow restrictors.

These plugs may take the form of ground quartz tapers mating with ground quartz sockets to make a substantially gas tight joint when in place. In both the embodiments, the apertures/ removable plugs are provided in the crossmember. However the principle of the invention merely requires that they are provided somewhere in the volume to be evacuated, for example in association with the source volume upstream of the flow restrictor, and in the case of figure 3 in association with the growth volume downstream of the flow restrictor, and a location on the source tube, and in the case of figure 3 a location on the growth tube, could additionally or alternatively be adopted.

The addition of removable plugs to the crossmember at least above the source vessels and in the preferred case in figure 3 also above the growth vessel allows initial pump down of the volume at least above the sources to be much improved. Even in the case of figure 2 this also provides some additional pumping to the growth region. In the preferred case of figure 3 much improved additional pumping to the growth region is effected via the additional aperture.

Figures 2 and 3 show the plugs removed from the crossmember allowing good pumping during an evacuation phase of operation. By means of a suitable mechanical feedthrough (137) and actuator (133) passing through the wall of the outer vacuum vessel without compromising vacuum integrity, the plugs are replaced during the temperature ramp to growth conditions prior to reaching a source temperature at which significant loss of material to the outer vacuum vessel.

This is shown by the configuration in Figure 4 in which the secondary apertures from the source (and in the case of figure 3 growth) zones are closed for a growth phase of operation. Flow from source to growth zone is now in the direction V in essentially conventional manner in that flow is effected through the flow restrictors (119) and via an aperture in the growth module downstream of the growth zone such as is the case in Figure 1. Thus, the apparatus of the invention may operate conventionally, for example in the manner of the figure 1 apparatus, in the growth phase, but evacuate much more efficiently in the evacuation phase of operation. The apparatus of the invention meets the apparently conflicting requirements for rapid and high quality evacuation of all zones prior to crystal growth but a substantially leak proof envelope with controlled and restricted flow through and out of the growth zone during crystal growth in admirable manner.

It is advantageous to allow the temperature of the source material to reach as high a temperature as possible, subject to preventing significant loss of material, prior to replacing the plugs in order to allow more effective outgassing of the sources, seed and quartzware.

The most problematic volumes to pump down are those respective source volumes upstream of the respective flow restrictors, and the plugs/ apertures in the embodiment of figure 2 are placed to give secondary flow paths (F) out of this volume. Some evacuation of the growth vessel may take place via the tail flow through the growth zone aperture. However, addition of a removable plug to the crossmember above the growth vessel as embodied in figure 3 may be desirable in many cases as further facilitating evacuation of the growth vessel.

In the illustrated embodiments, an additional effect is exploited to complement the effect of the removable plugs/ apertures in the crossmember above the source vessels. A small orifice at the upstream end of the source vessels provides an additional pumping path for the volume above the source material during evacuation via a leak flow through the source material. Many sources for evaporation in the growth phase are originally provided in a powder or similar unconsolidated form prior to heating that tends to consolidate on heating. In this unconsolidated form, the orifice is effective during evacuation prior to heating as a leak flow route from the source volume through the unheated and unconsolidated source material. However it has been found that with a suitably sized hole and a suitable temperature gradient for the source heater, compaction of the source material during heating will typically reduce leak flow loss during growth phase operation to a small fraction of the source mass. Thus, this may provide in practice a further secondary flow path during the evacuation phase that tends to close during the temperature ramp to growth conditions. Such a leak flow effect is optional, applicable to those materials that suitably consolidate, and envisaged as a supplementary rather than a principal secondary flow path for source zone evacuation.

The tubes shown in figures 1 to 4 are demountable with ground glass joints between the crossmember and the two vertical tubes allowing removal of grown crystals and replenishment of source material. An alternative means of providing a secondary flow path form the respective source volumes upstream of the respective flow restrictors can therefore be envisaged. The source tubes, growth tube and crossmember tube may simply be demounted (or not remounted) during the evacuation phase. This will require a differently configured mechanical feedthrough passing through the wall of the outer vacuum vessel without compromising vacuum integrity to reassemble the envelope assembly during the temperature ramp to growth conditions prior to reaching a source temperature at which significant loss of material to the outer vacuum vessel might occur.

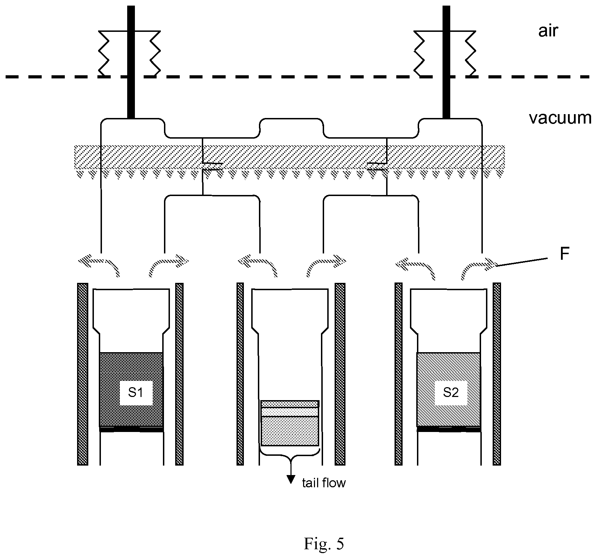

Such an arrangement is exemplified in figure 5, shown in an evacuation configuration with the crossmember raised. The skilled person will have no difficulty in envisioning the growth configuration with the crossmember lowered to complete a substantially leak proof flow path from source to growth zone.

Again the apparatus illustrated embodies similar principles to that of figure 1. A quartz tubular envelope is again provided made up of a pair of vertically disposed source tubes each defining a source zone at its lower end, a vertically disposed growth tube defining a growth zone at its lower end, and a crossmember tube. The whole assembly forms a quartz envelope volume defining a flow passage between each source zone and the growth zone. A first source is provided in the first source zone and a second source in the second source zone. Separate vertical tubular furnaces are provided for the source and the growth zones respectively. Flow restrictors in the crossmember tube substantially restrict flow between each source and the growth site. A vacuum jacket again surrounds the entire system.

The tubes are demountable with ground glass joints between them. A means to raise and lower the crossmember is provided. When the crossmember is raised, as in Figure 5, the source and growth vessels are open to the outer vacuum vessel and initial pump down may be improved. By means of a suitable mechanical feedthrough passing through the wall of the outer vacuum vessel without compromising vacuum integrity, the crossmember is lowered during the temperature ramp to growth conditions (not shown) prior to reaching a source temperature at which significant loss of material to the outer vacuum vessel might occur. Thus, again, the apparatus of the invention may operate conventionally, for example in the manner of the figure 1 apparatus, in the growth phase, but evacuate much more efficiently in the evacuation phase of operation without compromising the growth process.

This embodiment thus differs from that of figures 2 and 4 in the mechanism that is used to selectively open the source and growth vessels to the outer vacuum vessel during evacuation. Otherwise the principles embodied in relation to Figures 2 and 4 could be applied.

## Claims

1. An apparatus for vapour phase crystal growth comprising:
an envelope assembly (111, 113, 115) having at least one source module (111) defining at least one source volume, at least one growth module (113) defining at least one growth volume, and at least one manifold module (115) defining at least one manifold volume, wherein one or more source modules, a manifold module and a growth module are configured co-operably to define a fluidly continuous envelope volume including a flow restrictor (119) between each source volume and the growth volume;
a vacuum vessel containing one or more such envelope assemblies;
an evacuator to evacuate the vacuum vessel;
a fluid communication path (131) between the envelope volume and the vacuum vessel associated with each source volume at a location on the source volume side of its associated flow restrictor (119) that is configurable to be selectively openable;
a closure mechanism (135) configured to selectively restrict the fluid communication path (131).

2. An apparatus in accordance with claim 1 wherein a source module (111) defines a source zone spaced from the associated flow restrictor (119) and a fluid communication path between the envelope volume and the vacuum vessel comprises a direct fluid communication between the envelope volume and the vacuum vessel at a location between the source zone and the associated flow restrictor (119).

3. An apparatus in accordance with claim 1 or claim 2 additionally comprising:
a fluid communication path (132) between the envelope volume and the vacuum vessel at a location on the growth volume side of the flow restrictor(s) that is configurable to be selectively openable;
a closure mechanism (135) configured to selectively restrict the fluid communication path.

4. An apparatus in accordance with any preceding claim wherein a growth module (113) defines a growth zone spaced from the associated flow restrictor(s) and a fluid communication path between the envelope volume and the vacuum vessel comprises a direct fluid communication between the envelope volume and the vacuum vessel at a location between the growth zone and the flow restrictor(s).

5. An apparatus in accordance with any preceding claim configured alternatively and selectively to define:
an open configuration in which the fluid communication path(s) between the envelope volume and the vacuum vessel are open to allow direct flow from associated parts of the envelope to the vacuum vessel;
a closed configuration in which the fluid communication path(s) are selectively restricted to limit direct flow from associated parts of the envelope to the vacuum vessel;
a mechanically actuated closure mechanism (137) adapted to selectively and reversibly effect a change between the said open and closed configurations.

6. An apparatus in accordance with any preceding claim wherein a fluid communication path and closure mechanism is provided in that an aperture (131) with a removably insertable closure formation (135) is provided in a wall of a module (115) surrounding each part of the envelope volume on a source volume side of an associated source flow restrictor (119), an aperture (132) with a removably insertable closure formation is provided in a wall of a module surrounding that part of the envelope volume on a growth volume side of the source flow restrictor(s) (119), and each removably insertable closure formation comprises a plug (135) adapted to be removably received in a socket formation defining an aperture (131, 132) in the wall of the module in substantially leak tight manner.

7. An apparatus in accordance with any preceding claim wherein a fluid communication path and closure mechanism is provided in that one or more of the modules (111, 113, 115) making up the envelope volume are adapted to be selectively assemblable and dissassemblable from the whole.

8. An apparatus in accordance with any preceding claim wherein a fluid communication path and closure mechanism is provided in that there is an evacuation orifice upstream of a source zone and the source is provided in an unconsolidated form that tends to consolidate on heating whereby the orifice is open during evacuation prior to heating in that a flow route is provided from the source volume through the unconsolidated source material, but whereby the said flow route is restricted when the source material is consolidated on heating.

9. An apparatus in accordance with any preceding claim wherein the modules (111, 113, 115) are provided as discrete and demountable formations enabling assembly and disassembly of the fluidly continuous envelope prior to use and are adapted to be assembled in substantially leak tight manner to provide a substantially leak tight envelope volume when so assembled.

10. An apparatus in accordance with any preceding claim wherein a module (111, 113, 115) comprises a continuous tubular vessel wall structure defining an internal volume and extending between spaced first and second ends whereat fluid communication is effected with adjacent modules and /or where a closure or partial closure is provided in that the modules comprise glass tubes and are adapted to be connected to adjacent modules where applicable using mutually co-operating tapered ground glass seals.

11. An apparatus in accordance with any preceding claim wherein the envelope volume comprises a plurality of source zones in communication with a common growth zone.

12. A method of preparing an apparatus for vapour phase crystal growth comprising the steps of:
providing an envelope assembly (111, 113, 115) having at least one source module (111) defining at least one source volume, at least one growth module (113) defining at least one growth volume, and at least one manifold module (115) defining at least one manifold volume, wherein one or more source modules, a manifold module and a growth module are configured co-operably to define a fluidly continuous envelope volume including a flow restrictor (119) between each source volume and the growth volume;
defining a source zone in each source volume and providing a source (S1, S2) of growth material therein;
defining a growth zone in each growth volume, and optionally providing a seed crystal therein (123);
disposing one or more such envelope assemblies in a vacuum vessel, each configured in such manner that a fluid communication path between the envelope volume and the vacuum vessel is provided associated with each source volume at a location on the source volume side of its associated flow restrictor;
evacuating the vacuum vessel;
operating a closure mechanism configured to selectively restrict, and preferably substantially close, the fluid communication between each source volume and the vacuum vessel for a subsequent growth phase of operation.

13. A method in accordance with claim 12 wherein an aperture with a removably insertable closure formation (135) is provided in a wall of a module (115) surrounding the envelope volume and the method comprises the steps of removing the removably insertable closure formation (135) during an evacuation phase to provide direct fluid communication between the vacuum vessel and that part of the envelope volume and inserting the removably insertable closure formation (115) at the end of the evacuation phase in preparation for a growth phase such that direct fluid communication between the vacuum vessel and that part of the envelope volume is restricted.

14. A method in accordance with one of claims 12 or 13 wherein one or more of the modules (111, 113, 115) making up the envelope volume are provided such as to be selectively assemblable and dissassemblable from the whole and the method comprises the steps of disassembling the modules (111, 113, 115) during the evacuation phase whereby such part(s) of the envelope volume as are defined by the dissassemblabled modules are placed in direct fluid communication with the vacuum vessel and reassembling the modules (111, 113, 115) at the end of the evacuation phase in preparation for a growth phase whereby direct fluid communication between the vacuum vessel and said parts of the envelope volume restricted.

15. A method in accordance with one of claims 12 to 14 wherein an evacuation orifice is provided in a source module upstream of the source zone, and the method comprises providing a source material in a form that permits flow through the material when it is unheated during the evacuation phase, but which inherently tends to consolidate and restrict through flow when heated in preparation for a growth phase, so that the step of operating a closure mechanism configured to selectively the fluid communication between each source volume and the vacuum vessel for a subsequent growth phase of operation comprises the heating of the source for the growth phase.

## Patentansprüche

1. Eine Vorrichtung für das Kristallwachstum in der Dampfphase, beinhaltend:
eine Hüllenanordnung (111, 113, 115) mit mindestens einem Quellmodul (111), das mindestens ein Quellvolumen definiert, mindestens einem Wachstumsmodul (113), das mindestens ein Wachstumsvolumen definiert, und mindestens einem Verteilermodul (115), das mindestens ein Verteilervolumen definiert, wobei ein oder mehrere Quellmodule, ein Verteilermodul und ein Wachstumsmodul miteinander betriebsbereit konfiguriert sind, um ein fluidmäßig kontinuierliches Hüllenvolumen einschließlich einem Durchflussbegrenzer (119) zwischen jedem Quellvolumen und dem Wachstumsvolumen zu definieren;
einen Vakuumbehälter, der eine oder mehrere solcher Hüllenanordnungen enthält;
einen Evakuator, um den Vakuumbehälter zu leeren;
einen Fluidkommunikationspfad (131) zwischen dem Hüllenvolumen und dem Vakuumbehälter, jedem Quellvolumen an einer Stelle auf der Quellvolumenseite seines zugehörigen Durchflussbegrenzers (119) zugehörig, der konfigurierbar ist, um selektiv geöffnet werden zu können;
einen Schließmechanismus (135), der konfiguriert ist, um den Fluidkommunikationspfad (131) selektiv einzuschränken.

2. Vorrichtung gemäß Anspruch 1, wobei ein Quellmodul (111) eine Quellzone, von dem zugehörigen Durchflussbegrenzer (119) mit Abstand angeordnet, definiert, und ein Fluidkommunikationspfad zwischen dem Hüllenvolumen und dem Vakuumbehälter eine direkte Fluidkommunikation zwischen dem Hüllenvolumen und dem Vakuumbehälter an einer Stelle zwischen der Quellzone und dem zugehörigen Durchflussbegrenzer (119) beinhaltet.

3. Vorrichtung gemäß Anspruch 1 oder Anspruch 2, die zusätzlich Folgendes beinhaltet:
einen Fluidkommunikationspfad (132) zwischen dem Hüllenvolumen und dem Vakuumbehälter an einer Stelle auf der Wachstumsvolumenseite des Durchflussbegrenzers/der Durchflussbegrenzer, der konfigurierbar ist, um selektiv geöffnet werden zu können;
einen Schließmechanismus (135), der konfiguriert ist, um den Fluidkommunikationspfad selektiv einzuschränken.

4. Vorrichtung gemäß einem der vorhergehenden Ansprüche, wobei ein Wachstumsmodul (113) eine von dem zugehörigen Durchflussbegrenzer/den zugehörigen Durchflussbegrenzern mit Abstand angeordnete Wachstumszone definiert und ein Fluidkommunikationspfad zwischen dem Hüllenvolumen und dem Vakuumbehälter eine direkte Fluidkommunikation zwischen dem Hüllenvolumen und dem Vakuumbehälter an einer Stelle zwischen der Wachstumszone und dem Durchflussbegrenzer/den Durchflussbegrenzern beinhaltet.

5. Vorrichtung gemäß einem der vorhergehenden Ansprüche, die alternativ und selektiv konfiguriert ist, um Folgendes zu definieren:
eine offene Konfiguration, in der der Fluidkommunikationspfad/die Fluidkommunikationspfade zwischen dem Hüllenvolumen und dem Vakuumbehälter offen ist/sind, um den direkten Fluss von zugehörigen Teilen der Hülle zu dem Vakuumbehälter zu ermöglichen;
eine geschlossene Konfiguration, in der der Fluidkommunikationspfad/die Fluidkommunikationspfade selektiv eingeschränkt sind, um den direkten Fluss von zugehörigen Teilen der Hülle zu dem Vakuumbehälter zu limitieren;
einen mechanisch aktuierten Schließmechanismus (137), der angepasst ist, um selektiv und reversibel eine Änderung zwischen der offenen und der geschlossenen Konfiguration zu bewirken.

6. Vorrichtung gemäß einem der vorhergehenden Ansprüche, wobei ein Fluidkommunikationspfad und ein Schließmechanismus dadurch bereitgestellt sind, dass eine Öffnung (131) mit einer entfernbar einfügbaren Schließformation (135) in einer Wand eines Moduls (115), das jeden Teil des Hüllenvolumens auf einer Quellvolumenseite eines zugehörigen Quelldurchflussbegrenzers (119) umgibt, bereitgestellt sind, eine Öffnung (132) mit einer entfernbar einfügbaren Schließformation in einer Wand eines Moduls, das diesen Teil des Hüllenvolumens auf einer Wachstumsvolumenseite des Quelldurchflussbegrenzers/der Quelldurchflussbegrenzer (119) umgibt, bereitgestellt ist, und jede entfernbar einfügbare Schließformation einen Stopfen (135) beinhaltet, der angepasst ist, um entfernbar in einer Sockelformation, die ein Öffnung (131, 132) in der Wand des Moduls definiert, in einer im Wesentlichen undurchlässigen Weise aufgenommen zu werden.

7. Vorrichtung gemäß einem der vorhergehenden Ansprüche, wobei ein Fluidkommunikationspfad und ein Schließmechanismus dadurch bereitgestellt sind, dass ein oder mehrere der Module (111, 113, 115), die das Hüllenvolumen ausmachen, angepasst sind, um selektiv mit dem Ganzen aufbaubar und von diesem wieder abbaubar zu sein.

8. Vorrichtung gemäß einem der vorhergehenden Ansprüche, wobei ein Fluidkommunikationspfad und ein Schließmechanismus dadurch bereitgestellt sind, dass es oberhalb einer Quellzone einen Evakuierungsdurchlass gibt und die Quelle in einer nicht verfestigten Form bereitgestellt ist, die sich beim Erwärmen normalerweise verfestigt, wodurch der Durchlass vor dem Erwärmen während der Evakuierung offen ist, sodass eine Fließroute von dem Quellvolumen durch das nicht verfestigte Quellmaterial bereitgestellt wird, wodurch jedoch die Fließroute begrenzt ist, wenn sich das Quellmaterial beim Erwärmen verfestigt.

9. Vorrichtung gemäß einem der vorhergehenden Ansprüche, wobei die Module (111, 113, 115) als diskrete und demontierbare Formationen bereitgestellt sind, die das Aufbauen und Wiederabbauen der fluidmäßig kontinuierlichen Hülle vor der Verwendung ermöglichen und angepasst sind, um auf im Wesentlichen undurchlässige Weise aufgebaut zu werden, um, wenn so aufgebaut, ein im Wesentlichen undurchlässiges Volumen bereitzustellen.

10. Vorrichtung gemäß einem der vorhergehenden Ansprüche, wobei ein Modul (111, 113, 115) eine kontinuierliche röhrenförmige Behälterwandstruktur beinhaltet, die ein Innenvolumen definiert und sich zwischen mit Abstand angeordneten ersten und zweiten Enden erstreckt, wobei Fluidkommunikation mit benachbarten Modulen bewirkt wird und/oder wobei eine Schließung oder teilweise Schließung dadurch bereitgesellt wird, dass Module Glasröhren beinhalten und angepasst sind, um, wo zutreffend, unter Verwendung von wechselseitig zusammenwirkenden verjüngten Mattglasdichtungen mit benachbarten Modulen verbunden zu werden.

11. Vorrichtung gemäß einem der vorhergehenden Ansprüche, wobei das Hüllenvolumen eine Vielzahl von Quellenzonen in Kommunikation mit einer gemeinsamen Wachstumszone beinhaltet.

12. Ein Verfahren zum Präparieren einer Vorrichtung für das Kristallwachstum in der Dampfphase, das die folgenden Schritte beinhaltet:
Bereitstellen einer Hüllenanordnung (111, 113, 115) mit mindestens einem Quellmodul (111), das mindestens ein Quellvolumen definiert, mindestens einem Wachstumsmodul (113), das mindestens ein Wachstumsvolumen definiert, und mindestens einem Verteilermodul (115), das mindestens ein Verteilervolumen definiert, wobei ein oder mehrere Quellmodule, ein Verteilermodul und ein Wachstumsmodul miteinander betriebsbereit konfiguriert sind, um ein fluidmäßig kontinuierliches Hüllenvolumen umfassend einen Durchflussbegrenzer (119) zwischen jedem Quellvolumen und dem Wachstumsvolumen zu definieren;
Definieren einer Quellzone in jedem Quellvolumen und Bereitstellen einer Quelle (S1, S2) von Wachstumsmaterial darin;
Definieren einer Wachstumszone in jedem Wachstumsvolumen und optional Bereitstellen eines Impfkristalls darin (123);
Anordnen von einer oder mehreren derartigen Hüllenanordnungen in einem Vakuumbehälter, wobei jede auf eine solche Weise konfiguriert ist, dass ein Fluidkommunikationspfad zwischen dem Hüllenvolumen und dem Vakuumbehälter, jedem Quellvolumen an einer Stelle auf der Quellvolumenseite ihres zugehörigen Durchflussbegrenzers zugehörig, bereitgestellt ist;
Leeren des Vakuumbehälters;
Betreiben eines Schließmechanismus, der konfiguriert ist, um die Fluidkommunikation zwischen jedem Quellvolumen und dem Vakuumbehälter für eine nachfolgende Wachstumsphase des Betriebs selektiv einzuschränken und vorzugsweise im Wesentlichen zu schließen.

13. Verfahren gemäß Anspruch 12, wobei eine Öffnung mit einer entfernbar einfügbaren Schließformation (135) in einer Wand eines Moduls (115), das das Hüllenvolumen umgibt, bereitgestellt ist, und das Verfahren die Schritte des Entfernens der entfernbar einfügbaren Schließformation (135) während einer Evakuierungsphase beinhaltet, um direkte Fluidkommunikation zwischen dem Vakuumbehälter und dem Teil des Hüllenvolumens bereitzustellen und des Einfügens der entfernbar einfügbaren Schließformation (115) an dem Ende der Evakuierungsphase in Vorbereitung für eine Wachstumsphase, sodass direkte Fluidkommunikation zwischen dem Vakuumbehälter und dem Teil des Hüllenvolumens eingeschränkt wird.

14. Verfahren gemäß einem der Ansprüche 12 oder 13, wobei ein oder mehrere der Module (111, 113, 115), die das Hüllenvolumen ausmachen, bereitgestellt sind, um selektiv mit dem Ganzen aufbaubar und wieder abbaubar zu sein und das Verfahren die Schritte des Wiederabbauens der Module (111, 113, 115) während der Evakuierungsphase beinhaltet, wobei ein derartiger Teil/derartige Teile des Hüllenvolumens, wie durch die abgebauten Module definiert, in direkter Fluidkommunikation mit dem Vakuumbehälter gesetzt wird/werden, und des erneuten Aufbauens der Module (111, 113, 115) an dem Ende der Evakuierungsphase in Vorbereitung auf eine Wachstumsphase, wodurch direkte Fluidkommunikation zwischen dem Vakuumbehälter und den Teilen des Hüllenvolumens eingeschränkt wird.

15. Verfahren gemäß einem der Ansprüche 12 bis 14, wobei ein Evakuierungsdurchlass in einem Quellmodul oberhalb der Quellzone bereitgestellt ist und das Verfahren das Bereitstellen eines Quellmaterials in einer Form beinhaltet, die den Fluss durch das Material, wenn es nicht erwärmt ist, während der Evakuierungsphase erlaubt, das jedoch von Natur aus dazu neigt, den Durchfluss zu verfestigen und einzuschränken, wenn es in Vorbereitung auf eine Wachstumsphase erwärmt wird, sodass der Schritt des Betreibens eines Schließmechanismus, der konfiguriert ist, um die Fluidkommunikation zwischen jedem Quellvolumen und dem Vakuumbehälter für eine nachfolgende Wachstumsphase des Betriebs selektiv das Erwärmen der Quelle für die Wachstumsphase beinhaltet.

## Revendications

1. Un appareil pour la croissance cristalline en phase vapeur comprenant :
un assemblage d'enveloppe (111, 113, 115) ayant au moins un module de source (111) définissant au moins un volume de source, au moins un module de croissance (113) définissant au moins un volume de croissance, et au moins un module de rampe de distribution (115) définissant au moins un volume de rampe de distribution, dans lequel un ou plusieurs modules de source, un module de rampe de distribution et un module de croissance sont configurés de façon à pouvoir coopérer afin de définir un volume d'enveloppe fluidiquement continue incluant un dispositif de restriction de flux (119) entre chaque volume de source et le volume de croissance ;
une enceinte à vide contenant un ou plusieurs assemblages d'enveloppe de la sorte ;
un dispositif de mise sous vide afin de mettre sous vide l'enceinte à vide ;
une voie de communication fluidique (131) entre le volume d'enveloppe et l'enceinte à vide associée à chaque volume de source au niveau d'un emplacement sur le côté volume de source de son dispositif de restriction de flux associé (119) qui est configurable afin de pouvoir être ouverte de façon sélective ;
un mécanisme de fermeture (135) configuré afin de restreindre de façon sélective la voie de communication fluidique (131).

2. Un appareil conformément à la revendication 1 dans lequel un module de source (111) définit une zone de source espacée du dispositif de restriction de flux associé (119) et une voie de communication fluidique entre le volume d'enveloppe et l'enceinte à vide comprend une communication fluidique directe entre le volume d'enveloppe et l'enceinte à vide au niveau d'un emplacement entre la zone de source et le dispositif de restriction de flux associé (119).

3. Un appareil conformément à la revendication 1 ou à la revendication 2 comprenant de plus :
une voie de communication fluidique (132) entre le volume d'enveloppe et l'enceinte à vide au niveau d'un emplacement sur le côté volume de croissance du ou des dispositifs de restriction de flux qui est configurable afin de pouvoir être ouverte de façon sélective ;
un mécanisme de fermeture (135) configuré afin de restreindre de façon sélective la voie de communication fluidique.

4. Un appareil conformément à n'importe quelle revendication précédente dans lequel un module de croissance (113) définit une zone de croissance espacée du ou des dispositifs de restriction de flux associés et une voie de communication fluidique entre le volume d'enveloppe et l'enceinte à vide comprend une communication fluidique directe entre le volume d'enveloppe et l'enceinte à vide au niveau d'un emplacement entre la zone de croissance et le ou les dispositifs de restriction de flux.

5. Un appareil conformément à n'importe quelle revendication précédente configuré de façon alternative et sélective afin de définir :
une configuration ouverte dans laquelle la ou les voies de communication fluidique entre le volume d'enveloppe et l'enceinte à vide sont ouvertes afin d'autoriser un flux direct depuis des parties associées de l'enveloppe jusqu'à l'enceinte à vide ;
une configuration fermée dans laquelle la ou les voies de communication fluidique sont restreintes de façon sélective afin de limiter un flux direct depuis des parties associées de l'enveloppe jusqu'à l'enceinte à vide ;
un mécanisme de fermeture à actionnement mécanique (137) conçu afin d'effectuer de façon sélective et réversible un changement entre lesdites configurations ouverte et fermée.

6. Un appareil conformément à n'importe quelle revendication précédente dans lequel un mécanisme de voie de communication fluidique et de fermeture est fourni en ce qu'une ouverture (131) avec une formation de fermeture insérable de façon amovible (135) est fournie dans une paroi d'un module (115) entourant chaque partie du volume d'enveloppe sur un côté volume de source d'un dispositif de restriction de flux de source associé (119), une ouverture (132) avec une formation de fermeture insérable de façon amovible est fournie dans une paroi d'un module entourant cette partie du volume d'enveloppe sur un côté volume de croissance du ou des dispositifs de restriction de flux de source (119), et chaque formation de fermeture insérable de façon amovible comprend un bouchon (135) conçu afin d'être reçu de façon amovible dans une formation d'emboîture définissant une ouverture (131, 132) dans la paroi du module de manière substantiellement étanche.

7. Un appareil conformément à n'importe quelle revendication précédente dans lequel un mécanisme de voie de communication fluidique et de fermeture est fourni en ce qu'un ou plusieurs des modules (111, 113, 115) composant le volume d'enveloppe sont conçus afin d'être assemblables et désassemblables de façon sélective de l'ensemble.

8. Un appareil conformément à n'importe quelle revendication précédente dans lequel un mécanisme de voie de communication fluidique et de fermeture est fourni en ce qu'il y a un orifice de mise sous vide en amont d'une zone de source et la source est fournie sous une forme non consolidée qui tend à se consolider après chauffage grâce à quoi l'orifice est ouvert au cours de la mise sous vide préalablement au chauffage en ce qu'une trajectoire de flux est fournie depuis le volume de source à travers le matériau de source non consolidé, mais grâce à quoi ladite trajectoire de flux est restreinte lorsque le matériau de source est consolidé après chauffage.

9. Un appareil conformément à n'importe quelle revendication précédente dans lequel les modules (111, 113, 115) sont fournis en tant que formations discrètes et démontables permettant l'assemblage et le désassemblage de l'enveloppe fluidiquement continue préalablement à l'utilisation et sont conçus afin d'être assemblés de manière substantiellement étanche afin de fournir un volume d'enveloppe substantiellement étanche lorsqu'assemblés ainsi.

10. Un appareil conformément à n'importe quelle revendication précédente dans lequel un module (111, 113, 115) comprend une structure de paroi d'enceinte tubulaire continue définissant un volume interne et s'étendant entre des première et deuxième extrémités espacées à l'endroit desquelles une communication fluidique est effectuée avec des modules adjacents et/ou où une fermeture ou fermeture partielle est fournie en ce que les modules comprennent des tubes en verre et sont conçus afin d'être raccordés à des modules adjacents le cas échéant en utilisant des joints d'étanchéité en verre dépoli effilés qui coopèrent mutuellement.

11. Un appareil conformément à n'importe quelle revendication précédente dans lequel le volume d'enveloppe comprend une pluralité de zones de source en communication avec une zone de croissance commune.

12. Un procédé de préparation d'un appareil pour la croissance cristalline en phase vapeur comprenant les étapes consistant :
à fournir un assemblage d'enveloppe (111, 113, 115) ayant au moins un module de source (111) définissant au moins un volume de source, au moins un module de croissance (113) définissant au moins un volume de croissance, et au moins un module de rampe de distribution (115) définissant au moins un volume de rampe de distribution, dans lequel un ou plusieurs modules de source, un module de rampe de distribution et un module de croissance sont configurés de façon à pouvoir coopérer afin de définir un volume d'enveloppe fluidiquement continue incluant un dispositif de restriction de flux (119) entre chaque volume de source et le volume de croissance ;
à définir une zone de source dans chaque volume de source et à fournir une source (S1, S2) de matériau de croissance dans celle-ci ;
à définir une zone de croissance dans chaque volume de croissance, et à fournir facultativement un germe cristallin dans celle-ci (123) ;
à disposer un ou plusieurs assemblages d'enveloppe de la sorte dans une enceinte à vide, chacun configuré de telle manière qu'une voie de communication fluidique entre le volume d'enveloppe et l'enceinte à vide soit fournie associée à chaque volume de source au niveau d'un emplacement sur le côté volume de source de son dispositif de restriction de flux associé ;
à mettre sous vide l'enceinte à vide ;
à mettre en action un mécanisme de fermeture configuré afin de restreindre de façon sélective, et préférablement fermer substantiellement, la communication fluidique entre chaque volume de source et l'enceinte à vide pour une phase d'opération de croissance ultérieure.

13. Un procédé conformément à la revendication 12 dans lequel une ouverture avec une formation de fermeture insérable de façon amovible (135) est fournie dans une paroi d'un module (115) entourant le volume d'enveloppe et le procédé comprend les étapes consistant à enlever la formation de fermeture insérable de façon amovible (135) au cours d'une phase de mise sous vide afin de fournir une communication fluidique directe entre l'enceinte à vide et cette partie du volume d'enveloppe et à insérer la formation de fermeture insérable de façon amovible (115) à la fin de la phase de mise sous vide en préparation d'une phase de croissance de telle sorte qu'une communication fluidique directe entre l'enceinte à vide et cette partie du volume d'enveloppe soit restreinte.

14. Un procédé conformément à l'une des revendications 12 ou 13 dans lequel un ou plusieurs des modules (111, 113, 115) composant le volume d'enveloppe sont fournis de sorte à être assemblables et désassemblables de façon sélective de l'ensemble et le procédé comprend les étapes consistant à désassembler les modules (111, 113, 115) au cours de la phase de mise sous vide grâce à quoi cette ou ces parties du volume d'enveloppe qui sont définies par les modules désassemblables désassemblés sont placées en communication fluidique directe avec l'enceinte à vide et à réassembler les modules (111, 113, 115) à la fin de la phase de mise sous vide en préparation d'une phase de croissance grâce à quoi une communication fluidique directe entre l'enceinte à vide et lesdites parties du volume d'enveloppe restreinte.

15. Un procédé conformément à l'une des revendications 12 à 14 dans lequel un orifice de mise sous vide est fourni dans un module de source en amont de la zone de source, et le procédé comprend le fait de fournir un matériau de source sous une forme qui permet un flux à travers le matériau lorsqu'il est non chauffé au cours de la phase de mise sous vide, mais qui tend de façon inhérente à se consolider et à restreindre le flux traversant lorsque chauffé en préparation d'une phase de croissance, de sorte que l'étape consistant à mettre en action un mécanisme de fermeture configuré afin de de façon sélective la communication fluidique entre chaque volume de source et l'enceinte à vide pour une phase d'opération de croissance ultérieure comprend le chauffage de la source pour la phase de croissance.
